# EUROPEAN PATENT SPECIFICATION

(11) **EP 0 266 855 B1**
(45) Date of publication and mention of the grant of the patent: **27.09.1995**
(21) Application number: 87302592.8
(22) Date of filing: 25.03.1987
(51) Int. Cl.: H05K 5/02

(54) **Adaptor of a cartridge for gaming machine**
Zwischenstecker für eine Kassette in einem Spielgerät
Adaptateur de cassette pour machine de jeu

(30) Priority: 07.11.1986 JP 266079/86
(43) Date of publication of application: 11.05.1988
(73) Proprietor: NINTENDO CO. LIMITED, Higashiyama-ku Kyoto (JP)
(72) Inventor: Hibino, Toshiro, Higashiyama-ku, Kyoto-shi, Kyoto-fu (JP); Inoue, Yoshihiro, Higashiyama-ku, Kyoto-shi, Kyoto-fu (JP)
(74) Representative: Milhench, Howard Leslie

(56) References cited:
- DE-A- 2 822 968
- DE-A- 3 319 141
- FR-A- 2 505 590
- FR-A- 2 558 975
- GB-A- 2 115 989

## Description

### BACKGROUND OF THE INVENTION

### Field of the Invention

The present invention relates to an adaptor for a cartridge for a gaming machine and particularly to an adaptor for fitting a cartridge for a gaming machine of a specified standard to a gaming machine of another standard.

### Description of the Prior Art

A processing apparatus such as a home television game or a personal computer (for example, a product known by the trade name MSX) uses a replaceable memory cartridge (or a replaceable cartridge) containing a memory (for example, a ROM or a battery-backed-up RAM) which stores a program of software such as a game, quiz or education program, so that a CPU incorporated in the processing apparatus executes desired processing to display a result (or a process) of the processing on a home television set. Such cartridges and processing apparatuses are disclosed for example in Japanese Patent Laying-Open No. 2834/1979 and Japanese Patent Laying-Open No. 112352/1984. The processing apparatuses disclosed in these documents have an insertion opening in its upper surface for inserting a portion (a lower portion) of a cartridge and an edge connector is contained in a lower portion of the insertion opening. When a ROM cartridge is inserted in the insertion opening vertically from above the processing apparatus and is held in the edge connector, the cartridge is loaded into the main body of the processing apparatus. Such a system for loading a cartridge vertically into a main body of a processing apparatus is hereinafter referred to as a vertical loading system.

### Description of the Related Art

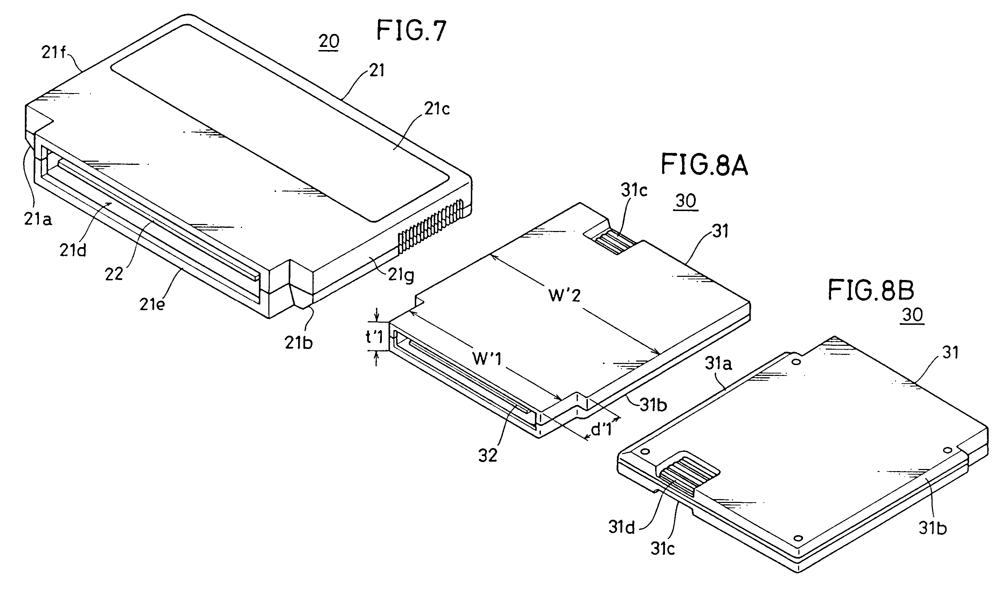

In EP-A-0217538, the applicant of the present invention proposed, as the related art forming a background to the present invention, a system for loading a cartridge from a front face of a main body of a gaming machine. In this system, an insertion opening for a cartridge is formed in a front face of a main body of a gaming machine and a front loading device 1 as shown in Fig. 12A is provided in an internal portion of the insertion opening. The front loading device 1 has a tray 2 for receiving a cartridge. The tray 2 is rotatably supported by a frame 3 and an edge connector 4 having a square shape in cross section is provided at an end of the tray 2. A circuit board of a cartridge 12 shown in Figs. 8A and 8B is inserted into the edge connector 4. After the cartridge 12 has been inserted, the tray 2 is moved downward and stopped in a horizontal state by a lock mechanism 5 so that the loading is completed. Such a system for loading a cartridge from a front face of a main body of a processing apparatus is hereinafter referred to as a front loading system.

Home television gaming machines do not have any unified standard for memory cartridges and manufacturers utilize various cartridges. In addition, even television gaming machines of the same company have different standards for cartridges dependent on the loading system. As a result, when users want to use cartridges of a standard different from the standard conforming to home television gaming machines they possess, they have to buy new home television gaming machines conforming to the different standard, which increases costs the users have to pay. In addition, such lack of interchangeability, even among products of the same company, is also not desirable for makers or dealers because they cannot give good service to users and it is necessary too for makers to manufacture cartridges of various standards, causing the manufacturing cost to be high.

In GB-A-2115989 there is disclosed an adaptor for a programmed cartridge for a video machine, comprising a housing which is electrically and mechanically couplable in a first region to a programmed cartridge of a first type, said cartridge being directly couplable to a video machine of the first type, and which is electrically and mechanically couplable in a second region to a video machine of a second type with which the cartridge of the first type is not directly compatible, the adaptor having means electrically adapting the cartridge to the machine to enable the cartridge of the first type to be used with the machine of the second type.

### SUMMARY OF THE INVENTION

According to the present invention there is provided a combination of a gaming machine having a cartridge loading port into which a game cartridge of a first, predetermined type may be loaded for playing a game, a second type of plug-in game cartridge which is not of said first, predetermined type, and an adaptor having a first portion adapted to be plugged into the cartridge loading port and a second portion adapted to receive said second type plug-in game cartridge, as is known from GB-A-2115989 abovementioned, the combination according to the invention being characterised in that said gaming machine comprises a lock circuit for prohibiting the playing of a game with a game cartridge not of said first, predetermined type, and said adaptor comprises a circuit connecting said first and second portions and including means arranged to cancel the action of said lock circuit so that when the adaptor is plugged into the cartridge loading port of the gaming machine and said second type plug-in game cartridge is received in the second portion of the adaptor the playing of a game with said second type plug-in game cartridge is permitted.

Briefly stated, an embodiment of the present invention which is described hereinafter is an adaptor for adapting a cartridge for a first gaming machine to a second gaming machine. This adaptor contains a connection board and a connector in a case comprising an upper half and a lower half. At least a portion of the case is formed to have a shape adapted for the second gaming machine and a guide support means for the cartridge for the first gaming machine is formed in another portion of the case.

In the described embodiment, the guide support means formed in the case serves as a guide for loading of the cartridge of the first gaming machine so as to precisely position the cartridge and the adaptor, and after the loading, the guide support means supports the cartridge to maintain the loading of the cartridge in a stable state.

Thus, the present invention enables a cartridge of a certain gaming machine to be loaded reliably and stably into a gaming machine of another standard and thus interchangeability of cartridges can be attained. In addition, the guide support means guides and receives therein the cartridge when it is loaded into the gaming machine and consequently, positioning of a contact of the circuit board of the cartridge and a contact of the connector in the adaptor can be performed with precision.

These above and other features and aspects of the present invention are recited with particularity in the appended claims and will become more apparent from the following detailed description when taken in conjunction with the accompanying drawings.

### BRIEF DESCRIPTION OF THE DRAWINGS

Fig. 1 is a perspective view showing an embodiment of the present invention;
Fig. 2 is a perspective exploded view of the embodiment shown in Fig. 1;
Fig. 3 is a perspective view showing a state in which an upper half is removed from the embodiment shown in Fig. 1;
Fig. 4 is a sectional view taken along the line A-A shown in Fig. 1;
Fig. 5 is a perspective view showing an adaptor as shown in Figs. 1 to 4 to which a cartridge is attached;
Fig. 6 is a sectional view taken along the line B-B shown in Fig. 5;
Fig. 7 is a perspective view showing an example of a cartridge for a vertical loading system;
Figs. 8A and 8B are perspective views showing an example of a cartridge for a front loading system, Fig. 8A showing an upper surface thereof and Fig. 8B showing a lower surface thereof;
Figs. 9 and 10 are views showing examples of means for preventing reverse loading of a cartridge;
Fig. 11 is a block diagram showing an example of a home television game system using the embodiment shown in Figs. 1 to 6; and
Figs. 12A and 12B show an example of a front loading apparatus incorporated in a gaming machine to which the present invention is applied, Fig. 12A being a perspective view thereof and Fig. 12B being a front view thereof partially in section.

### DESCRIPTION OF THE PREFERRED EMBODIMENTS

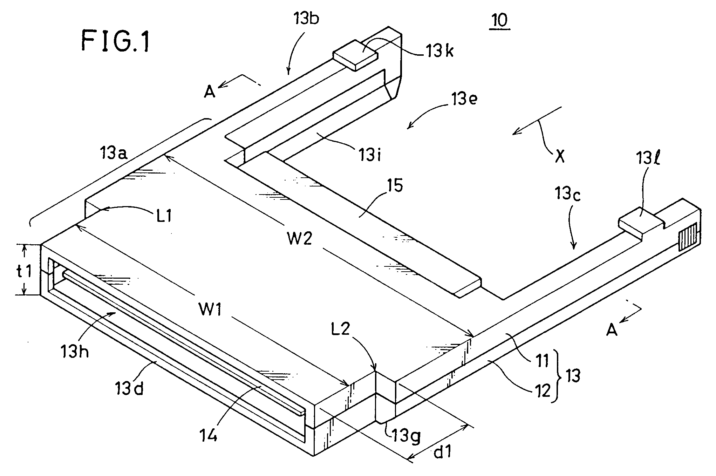

An embodiment of the present invention as shown in Figs. 1 to 4 is an adaptor for using, as a memory cartridge 30 of a front loading system shown in Figs. 8A and 8B, a memory cartridge 20 of a vertical loading system as shown in Fig. 7 containing a ROM or a RAM backed up by battery. Referring first to Figs. 1 to 4, construction of this embodiment will now be described.

The adaptor 10 as shown in Figs. 1 to 4 comprises a case 13 formed by an upper half 11 and a lower half 12, a connection board 14 housed in this case 13, and a two-edge connector 15. The case 13 comprises a main body portion 13a and a guide support means 13b, 13c. The main body portion 13a occupies a nearly half area of the case 13 from a front edge 13d to the guide support means 13b, 13c. The guide support means 13b, 13c are formed by extensions of the two side portions of the main body portion 13a. Consequently, a receiving space 13e surrounded by the back end of the main body portion 13a and the inner side faces of the guide support means 13b, 13c is formed at the rear of the main body portion 13a. A cartridge 20 as shown in Fig. 7 is fitted in the receiving space 13e. The external shape and size of the case 13 are selected to be almost equal to an external shape and size of a cartridge 30 as shown in Figs. 8A and 8B. More specifically, the main body portion 13a has L-shaped steps L1 and L2 on both sides thereof so that a width W1 near the front edge 13d of the case 13 is smaller than a width W2 in the other portion of the case 13. Those widths W1 and W2 are almost equal to a width W′1 and a width W′2, respectively, in the corresponding portions as shown in Fig. 8A. A distance dl from the front edge 13d to the respective ends of the steps L1 and L2 is almost equal to a distance d′1 in the corresponding portion as shown in Fig. 8A. A thickness t1 of the case 13 is almost equal to a thickness t′1 of the cartridge 30. In addition, tapers 13f, 13g are formed in both lower side portions of the lower half 12 of the case 13 in the same manner as in the cartridge 30 in which tapers 31a, 31b are formed in both lower side portions. The tapers 13f, 13g serve to prevent the adaptor 10 from being inserted in the main body of the gaming machine upside down. More specifically, the main body of the gaming machine is constructed to receive the cartridge 30 only when the adaptor 10 is inserted with the faces having the tapers 13f, 13g being directed downward. An opening 13h is formed in the front edge 13d of the case 1 so that a part of an edge portion of the connection board 14 is accessible from the opening 13h.

The back edge of the main body portion 13a and the inner side faces of the guide support means 13b, 13c which define the above stated receiving space 13e have a shape and a size substantially equal to the shape and the size of the cartridge 20. Tapers 13i, 13j are formed on both inner lower side faces of the lower half 12 in the guide support means 13b, 13c so as to fit to the tapers 21a, 21b formed on the two lower side faces of the case 21 of the cartridge 20. As a result, the cartridge 20 is prevented from being inserted upside down.

In association with the receiving space 13e, projecting pieces 13k, 13l which project toward the receiving space 13e are formed on the respective upper surfaces of the guide support means 13b, 13c. Those projecting pieces 13k, 13l serve to guide a surface 21c of the cartridge 20 when it is inserted into the receiving space 13e and to maintain the fixed position of the surface 21c after insertion.

The connection board 14 has a first connection terminal group 14a on an edge portion thereof and a second connection terminal group 14b on the other edge portion thereof. The shape, the positioning or pitches and the number of terminals of the first connection terminal group 14a are selected to be engaged with the main body of a gaming machine into which the adaptor 10 is inserted. More specifically, the number of terminals of the first group 14a is selected to be equal to the number of terminals formed on the circuit board 32 contained in the cartridge 30. On the other hand, the number of terminals of the second group 14b is selected to be equal to the number of terminals of the circuit board 22 contained in the cartridge 20.

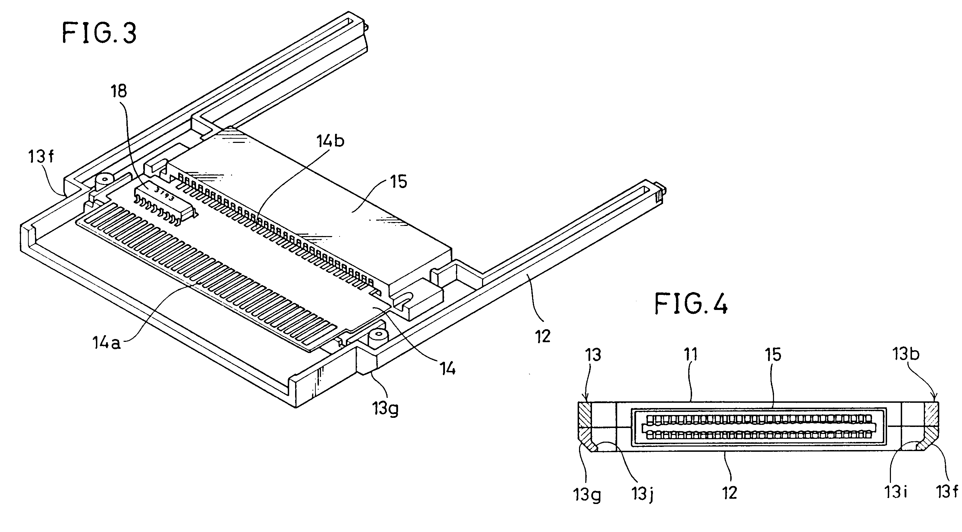

The two-edge connector 15 has insertion openings on both sides thereof so that two circuit boards inserted from the respective sides are electrically connected therein. One of the insertion openings of the two-edge connector 15 receives the above stated other edge portion of the connection board 14, namely, the other edge portion on which the second connection terminal group 14b are formed. The other insertion opening of the two-edge connector 15 receives the circuit board 22 of the cartridge 20 when the cartridge 20 is inserted. For this purpose, the shape and the size of the two-edge connector 15 are selected so that the two-edge connector 15 is received in the opening 21d formed at the front edge 21e of the cartridge 20. The two-edge connector 15 and the connection board 14 inserted into the connector 15 are placed on the lower half 12 and fixed thereto by screws (see Fig. 3). At this time, the two-edge connector 15 is disposed so that a part of the connector 15 projects backward from the lower half 12. Further, the upper half 11 is fixed on the lower half 12 so that assembling of the adaptor 10 is completed as shown in Fig. 1.

At the time of fixing the upper half 11 to the lower half 12, the upper half 11 is fixed by screws in the main body portion 13a; however, the guide support means 13b, 13c do not have any space for screws and, therefore, fixing of the upper half 11 in the guide support means is effected in the following manner. The end portions of the guide support means 13b, 13c of the lower half 12 have projections protruding outwardly. The end portions of the guide support means 13b, 13c of the upper half 11 are L-shaped and bent downward. These L-shaped end portions have holes for receiving the above stated projections at positions opposed to the end portions of the lower half 12. As a result, when the upper half 11 is connected with the lower half 12, the projections formed at the end portions of the lower half 12 are engaged with the holes formed in the L-shaped end portions of the upper half 11, whereby the upper half 11 is engaged by the lower half 12.

A state of application of the above described embodiment will now be described. The cartridge 20 is inserted into the adaptor 10 along the direction of the arrow X as shown in Fig. 1 with the front edge 21e of the cartridge 20 being introduced first. The side faces 21f, 21g of the cartridge 20 contact the inner side faces of the guide support means 13b, 13c, and the upper surface 21c contacts the lower surfaces of the projecting pieces 13k, 13l. Thus, the cartridge 20 is guided by the guide support means 13b, 13c and the projecting pieces 13k, 13l so that the cartridge 20 can be inserted into the adaptor 10 smoothly and correctly. If the cartridge 20 is intended to be inserted with the upper surface 21c thereof being directed downward, the tapers 13i, 13j of the guide support means 13b, 13c respectively, serve as obstacles to insertion of the cartridge 20 and, thus, the cartridge 20 can be prevented from being inserted upside down.

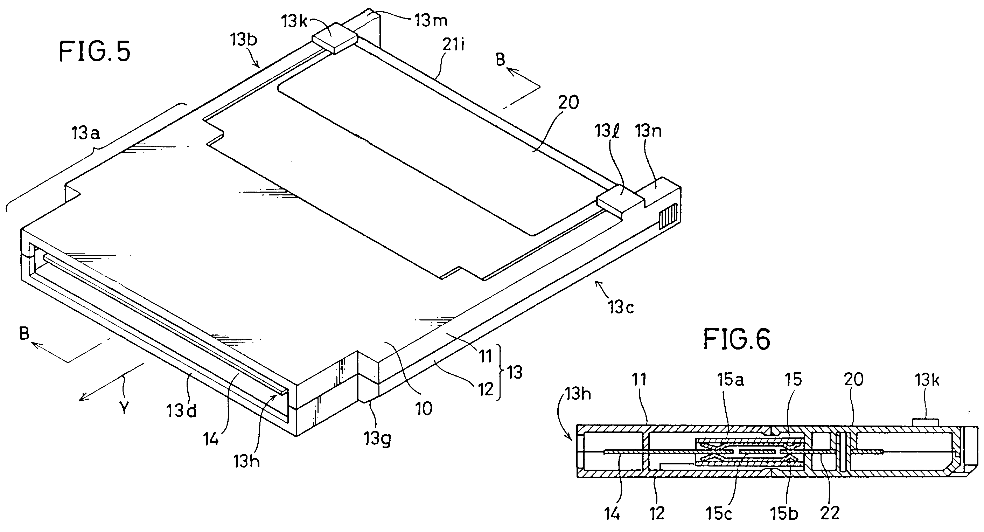

Fig. 5 is a perspective view showing a state in which insertion of the cartridge 20 is completed. Fig. 6 is a sectional view taken along the line B-B as shown in Fig. 5. As shown, an edge portion of the two-edge connector 15 is received in the opening 21d of the cartridge 20 and a portion of the circuit board 22 is inserted into the two-edge connector 15. Upper contact terminals 15a and lower contact terminals 15b are provided on the two-edge connector 15 for the respective terminals of the circuit board 22. The respective two ends of the upper and lower contact terminals 15a, 15b are bent into a square shape so that the upper and lower contact terminals 15a, 15b have elasticity. Consequently, when the circuit board 22 is inserted into the two-edge connector 15, the terminals of the circuit board 22 are held between the upper and lower contact terminals 15a, 15b so as to be stably in contact with the upper and lower contact terminals 15a, 15b. The elasticity of the upper and lower contact terminals 15a, 15b also serves to support the circuit board 22. Similarly, the connection board 14 is also held between the upper and lower contact terminals 15a, 15b and, thus, a good contact state is obtained and the connection board 14 is supported by the upper and lower contact terminals 15a, 15b. A spacing member 15c is provided in a central portion of the two-edge connector 15 so as to provide a suitable space between the boards inserted from both sides.

As is evident from Figs. 5 and 6, the cartridge 20 is supported by the two-edge connector 15, the inner side faces of the guide support means 13b, 13c and the lower surfaces of the projecting pieces 13k, 13l. Thus, the cartridge 20 inserted in the adaptor can be stably supported without any undesirable movement in the vertical direction. Thus, defective contact, damage or the like can be avoided.

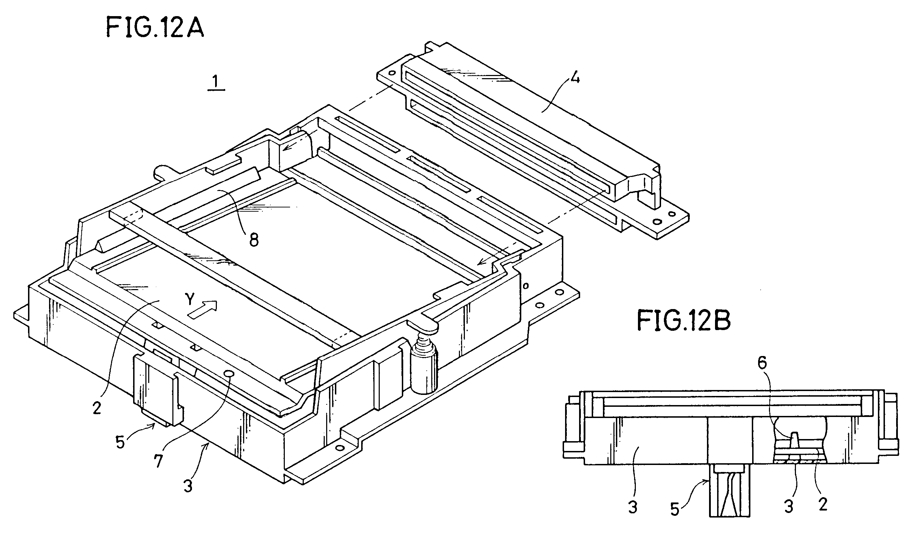

As shown in Figs. 8A and 8B, depressed portions 31c, 31d are formed on the upper and lower surfaces, respectively, of a case 31 of the cartridge 30. These depressed portions 31c, 31d are held by fingers when the cartridge 30 is taken out from the main body of the gaming machine. The depressed portion 31d formed on the lower surface also serves for mechanical determination as to a true or false state of the cartridge 30 dependent on the shape or the position of the depressed portion 31d. More specifically, a projection 6 of a prescribed height is formed in a prescribed position of the frame 3 of the front loading device (as shown in Figs. 12A and 12B) incorporated in the main body of the gaming machine and a hole 7 is provided in the tray 2 in a position opposed thereto. When the cartridge 30 is placed on the tray 2, the projection 6 is inserted into the depressed portion 31d through the hole 7. If a cartridge not containing the depressed portion 31d or a cartridge having a depressed portion at a different position or height is inserted into the main body of the gaming machine, the projection 6 obstructs insertion of the cartridge. Thus, only the cartridge 30 of the compatible standard can be inserted, whereby a true or false state is mechanically determined. On the other hand, as shown in Fig. 5 the ends 13m, 13n of the guide support means 13b, 13c, respectively, of the adaptor 10 project beyond the end 21i of the cartridge 20 when the cartridge 20 is inserted into the adaptor 10. As a result, the loading of the adaptor 10 is not obstructed by the projection 6.

As described above, the adaptor 10 to which the cartridge 20 is attached is inserted into the front loading device of the main body of the gaming machine along the direction of the arrow Y (as shown in Figs. 5 and 12A) with the front edge 13d thereof being inserted first. If the adaptor 10 is inserted with the back surface of the lower half 12 being directed upward, an elongate projection 8 in triangular section of the front loading device 1 obstructs the insertion of the adaptor 10 and thus reversed insertion of the adaptor 10 can be prevented.

In the above described embodiment, the tapers 21a, 21b are formed in the cartridge 20 and the tapers 13i, 13j are formed in the guide support means 13b, 13c so that the cartridge 20 can be prevented from being inserted in the adaptor 10 upside down. However, other means may be formed to prevent such reversed insertion.

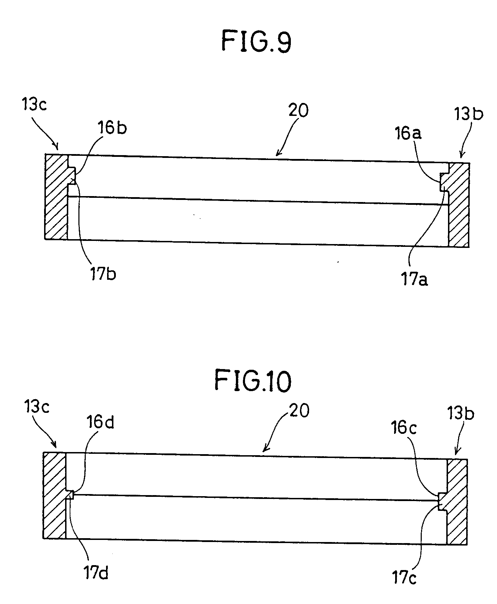

For example, as shown in Fig. 9, grooves 16a, 16b may be formed in the side faces of the cartridge 20 at positions a little away from the respective centers of the side faces, while projections 17a, 17b to be engaged with the grooves 16a, 16b, respectively, may be formed on the inner side faces of the guide support means 13b, 13c, respectively. In this case, if it is attempted to insert the cartridge 20 upside down, the grooves 16a, 16b are not engaged with the projections 17a, 17b, respectively, and thus reversed insertion of the cartridge 20 is obstructed. In addition, as shown in Fig. 10, grooves 16c, 16d having different widths may be formed in the side faces of the cartridge 20 and projections 17c, 17d to be engaged with the grooves 16c, 16d, respectively, may be formed on the inner side faces of the guide support means 13b, 13c, respectively. In this case, as in the case of Fig. 9, if it is attempted to insert the cartridge 20 upside down, the grooves 16c, 16d are not engaged with the projections 17c, 17d, respectively, thereby preventing reversed insertion of the cartridge 20. Alternatively, grooves may be formed in the guide support means 13b, 13c and projections may be formed on the cartridge 20.

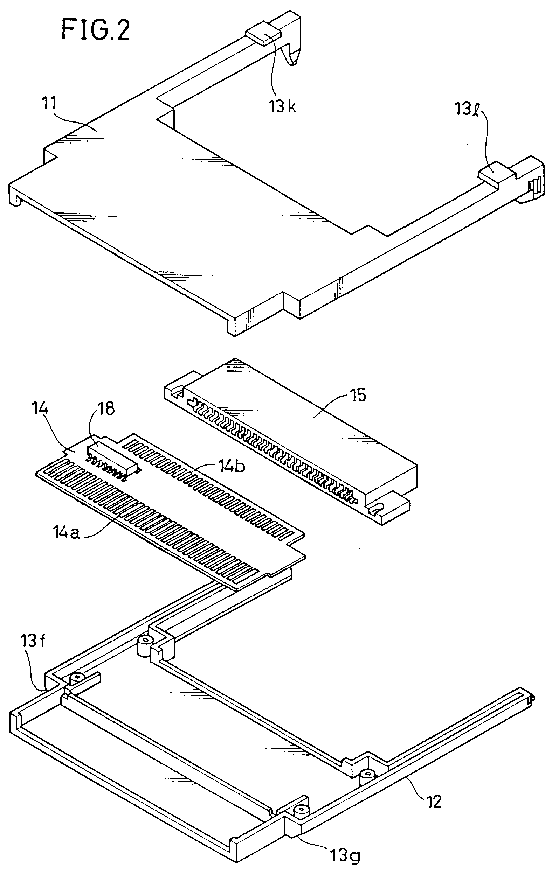

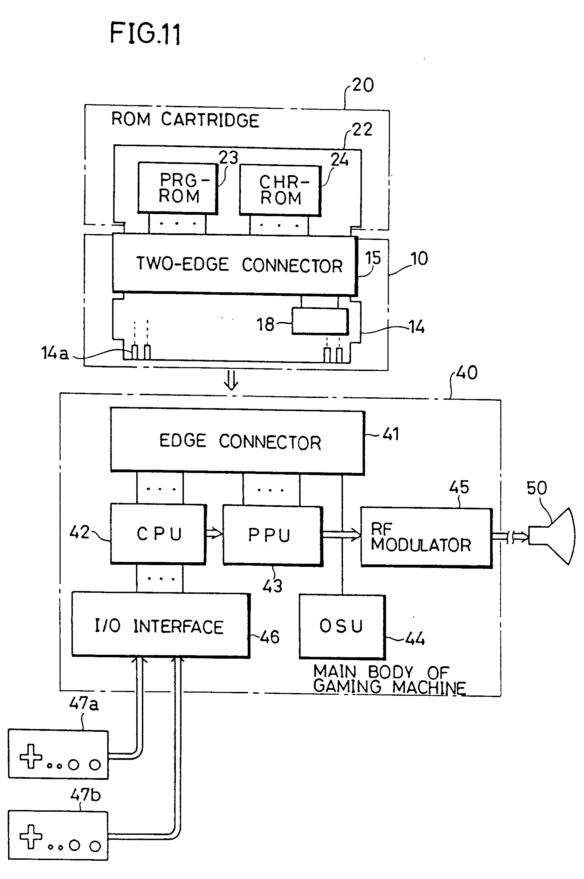

Fig. 11 is a block diagram showing an example of a home television game system in which the embodiment as shown in Figs 1 to 6 is used. Referring to Fig. 11, a program ROM 23 and a character ROM 24 are provided on the circuit board 22 of the cartridge 20. A program to be executed in the main body 40 of the gaming machine, namely, software for games and the like is stored in the program ROM 23. Information concerning various characters to be displayed on the home television receiver 50 is stored in the character ROM 24. When the cartridge 20 is inserted into the adaptor 10, output terminals of the program ROM 23 and the character ROM 24 are connected to the second connection terminal group 14b (as shown in Fig. 2) of the connection board 14 through the two-edge connector 15. A signal received by the terminals of the second connection terminal group 14b is subjected to address conversion in an integrated circuit element 18 and an output of the address conversion is supplied to the first connection terminal group 14a. When the adaptor 10 is inserted in the main body 40 of the gaming machine, the first connection terminal group 14a is connected to an edge connector 41. The edge connector 41 is connected with a CPU 42, a PPU (picture processing unit) 43 and an oscillator 44. The CPU 42 controls operation of the internal circuits of the main body 40 of the gaming machine. The PPU 43 performs processing for picture display based on the information supplied from the CPU 42, and an output of the PPU 43 is supplied to the television receiver 50 through an RF modulator 45. The CPU 42 is connected with an I/O interface 46 for connection with external apparatuses. In this embodiment, game controllers 47a, 47b are connected as external apparatuses. Accordingly, in this case, the CPU 42 controls the progression of a game in response to instructions provided from the game controllers 47a and 47b.

A lock circuit for preventing the starting of a game on a non-compatible cartridge is provided in the main body 40 of the gaming machine, and a program for cancelling the locking is stored in the integrated circuit element 18 of the adaptor 10. By this means, a game can be started with a non-compatible cartridge only when an adaptor 10 of a compatible type is loaded in the main body 40 of the gaming machine. Thus operation with a false adaptor 10 can be prohibited.

Although the above described embodiment is related to the adaptor 10 for using the cartridge 20 of the vertical loading system as the cartridge 30 of the front loading system, the present invention may be formed as an adaptor for attaining interchangeability from a cartridge of the front loading system to a cartridge of the vertical loading system, or interchangeability between cartridges of the vertical loading system or cartridges of the horizontal loading system. If cartridges of the vertical loading system are interchanged, a portion of a cartridge is inserted into the main body of the gaming machine and accordingly an adaptor in this case may be shaped so that at least the inserted portion may be engaged with the main body of the gaming machine.

## Claims

1. A combination of a gaming machine (40) having a cartridge loading port into which a game cartridge of a first, predetermined type may be loaded for playing a game, a second type of plug-in game cartridge (20) which is not of said first, predetermined type, and an adaptor (10) having a first portion (14a) adapted to be plugged into the cartridge loading port and a second portion (15) adapted to receive said second type plug-in game cartridge (20), characterised in that said gaming machine comprises a lock circuit for prohibiting the playing of a game with a game cartridge not of said first, predetermined type, and said adaptor (10) comprises a circuit (14) connecting said first and second portions (14a, 15) and including means (18) arranged to cancel the action of said lock circuit so that when the adaptor (10) is plugged into the cartridge loading port of the gaming machine (40) and said second type plug-in game cartridge (20) is received in the second portion (15) of the adaptor (10) the playing of a game with said second type plug-in game cartridge (20) is permitted.

2. The combination claimed in claim 1 wherein said adaptor (10) comprises:
a case (13) comprising an upper half (11) and a lower half (12), said case being formed to have a portion (13a) at least part of which is adapted to fit into said gaming machine (40) and, at positions opposite to said portion (13a), guide support means (13b, 13c) for guiding loading of said second type plug-in game cartridge (20) into the adaptor (10) and supporting said cartridge (20) after it has been loaded therein;
a circuit board (14) contained in said case (13) and having an edge on which a first group (14a) of connection terminals adapted for connecting to said gaming machine (40) are arrayed, and another edge on which a second group (14b) of connection terminals adapted for connecting to said second type plug-in game cartridge (20) are arrayed; and
a connector (15) for electrically connecting said group (14b) of connection terminals to said cartridge (20) when it is loaded in said adaptor (10), at least a portion of said connector (15) being housed in said case (13).

3. The combination claimed in claim 2, wherein
said second type plug-in game cartridge (20) has a generally rectangular parallelepipedal shape, and
said guide support means (13b, 13c) of the adaptor (10) are formed in a shape adapted for guiding and supporting opposed sides of said cartridge (20) along the direction in which it is loaded into the adaptor.

4. The combination claimed in claim 2 or 3 wherein said guide support means is arranged so as to prevent loading of said second type plug-in game cartridge (20) into the adaptor (10) in an upside down orientation.

5. The combination claimed in claim 4, wherein said guide support means (13b, 13c) have tapers (13i, 13j) formed on inner side faces thereof for co-operation with similar tapers on the cartridge (20) for preventing said cartridge (20) from being loaded upside down.

6. The combination claimed in claim 4, wherein said guide support means (13b, 13c) have projections (17a to 17d) formed on the inner side faces thereof for cooperation with grooves (16a to 16d) formed on the cartridge (20) for preventing said cartridge (20) from being loaded upside down.

7. The combination claimed in claim 4, wherein said guide support means (13b, 13c) have grooves formed on the inner side faces thereof for co-operation with projections formed on the cartridge (20) for preventing said cartridge (20) from being loaded upside down.

8. The combination claimed in any of claims 2 to 7, wherein said guide support means (13b, 13c) have projecting pieces (13k, 13l) for guiding and supporting at least either an upper surface or a lower surface of said cartridge (20).

9. The combination claimed in any of claims 2 to 8, wherein said guide support means (13b, 13c) of the adaptor (10) have end portions formed so that said upper half (11) and said lower half (12) engage with each other.

10. The combination claimed in claim 9, wherein said upper half (11) or said lower half (12) of the case (13) has a bend at the ends of said guide support means (13b, 13c) so as to cause either end portions of said upper half (11) or end portions of said lower half (12) to be opposed to respective end portions of the other of said upper half (11) and said lower half (12), a hole being formed in said upper half (11) or said lower half (12) at said opposed end portions, a projection for engagement with said hole being formed in the other one of said lower half (12) and said upper half (11), and engagement of said projection into said hole causing said upper half (11) and said lower half (12) to engage with each other.

11. The combination claimed in any of claims 2 to 10, wherein the length of each of said guide support means (13b and 13c) is selected to cause the ends thereof to project beyond the end (21i) of said cartridge (20) when said cartridge (20) is loaded in said adaptor (10).

12. The combination claimed in any of claims 2 to 11, wherein the adaptor (10) is arranged so as to prevent upside down insertion of said portion (13a) thereof into said gaming machine (40).

13. The combination claimed in claim 12, wherein both sides of said part of said portion (13a) which is adapted to fit into the second gaming machine have tapers (13f, 13g) for co-operation with said second gaming machine for preventing said case (13) from being inserted upside down.

14. The combination claimed in any of claims 2 to 13, wherein said circuit board (14) comprises address conversion means (18) for performing address conversion between input and output signals of said first group (14a) of connection terminals and input and output signals of said second group (14b) of connection terminals.

15. The combination claimed in any of the preceding claims, wherein said adaptor (10) is formed so as to enable a cartridge for a gaming machine having a vertical or horizontal loading system to be used with a gaming machine of a horizontal or vertical loading system.

16. The combination claimed in any of claims 1 to 14, wherein said adaptor (10) is formed so as to enable a cartridge of a gaming machine having a vertical or horizontal loading system to be used with a gaming machine having a vertical or horizontal loading system of a different standard.

## Patentansprüche

1. Kombination aus einem Spielgerät (40) mit einer Kassettenladeöffnung, in die eine Spielkassette von erstem, vorgegebenem Typ zum Spielen eines Spiels geladen werden kann, einer einsteckbaren Spielkassette (20) von zweitem, zum ersten unterschiedlichem Typ, und einem Zwischenstecker (10) mit einem in die Kassettenladeöffnung einsteckbaren ersten Teil (14a) und einem zweiten Teil (15), der die einsteckbare Spielkassette (20) vom zweiten Typ aufnimmt; **dadurch gekennzeichnet**, daß das Spielgerät eine Sperrschaltung zum Verhindern des Spielens eines Spiels mit einer Spielkassette nicht vom ersten, vorgegebenen Typ aufweist, und der Zwischenstekker (10) eine den ersten und zweiten Teil (14a, 15) verbindende Schaltung (14) aufweist, mit einer Einrichtung (18), die so ausgebildet ist, daß sie die Wirkung der Sperrschaltung aufhebt, so daß dann, wenn der Zwischenstecker (10) in die Kassettenladeöffnung des Spielgeräts (40) eingesteckt wird und die zweite, einsteckbare Spielkassette (20) im zweiten Teil (15) des Zwischensteckers (10) aufgenommen ist, das Spielen eines Spiels mit der zweiten, einsteckbaren Spielkassette (20) ermöglicht ist.

2. Kombination nach Anspruch 1, bei der der Zwischenstekker (10) folgendes aufweist:
- ein Gehäuse (13) mit einer oberen Hälfte (11) und einer unteren Hälfte (12), das so ausgebildet ist, daß es einen Bereich (13a) aufweist, von dem mindestens ein Teil so ausgebildet ist, daß er in das Spielgerät (40) paßt, und daß es an diesem Bereich (13a) gegenüberliegenden Positionen führende Halteeinrichtungen (13b, 13c) aufweist, um den zweiten Typ einer einsteckbaren Spielkassette (20) auf führende Weise in den Zwischenstecker (40) zu laden und die Kassette (40) zu halten, nachdem sie in diesen geladen wurde;
- eine Leiterplatte (14) im Gehäuse (13), mit einer Kante, an der eine erste Gruppe (14a) von Verbindungsanschlüssen angeordnet ist, die so ausgebildet sind, daß sie eine Verbindung zum Spielgerät (40) herstellen, und mit einer anderen Kante, an der eine zweite Gruppe (14b) von Verbindungsanschlüssen angeordnet ist, die so ausgebildet sind, daß sie eine Verbindung zur einsteckbaren Spielkassette (20) vom zweiten Typ herstellen; und
- einen Verbinder (15) zum elektrischen Verbinden der Gruppe (14b) von Verbindungsanschlüssen mit der Kassette (20), wenn diese in den Zwischenstecker (10) geladen ist, wobei mindestens ein Teil des Verbinders (15) im Gehäuse (13) untergebracht ist.

3. Kombination nach Anspruch 2, bei der
- die einsteckbare Spielkassette (20) vom zweiten Typ im wesentlichen Quaderform aufweist und
- die führenden Halteeinrichtungen (13b, 13c) des Zwischensteckers (10) mit einer Form ausgebildet sind, die dergestalt ist, daß entgegengesetzte Seiten der Kassette (20) entlang der Richtung, in der sie in den Zwischenstecker geladen wird, geführt und gehalten werden.

4. Kombination nach einem der Ansprüche 2 oder 3, bei der die führenden Halteeinrichtungen so ausgebildet sind, daß sie ein Laden der einsteckbaren Spielkassette (20) vom zweiten Typ in den Zwischenstecker (10) mit einer Ausrichtung verhindern, bei der die Oberseite nach unten zeigt.

5. Kombination nach Anspruch 4, bei der die führenden Halteeinrichtungen (13b, 13c) Schrägen (13i, 13j) aufweisen, die an ihren Innenseiten ausgebildet sind, um mit ähnlichen Schrägen an der Kassette (20) zusammenzuwirken, um zu verhindern, daß die Kassette (20) mit der Oberseite nach unten geladen wird.

6. Kombination nach Anspruch 4, bei der die führenden Halteeinrichtungen (13b, 13c) über Vorsprünge (17a bis 17d) verfügen, die an ihren Innenseiten ausgebildet sind, um mit Nuten (16a bis 16d) zusammenzuwirken, die an der Kassette (20) ausgebildet sind, um zu verhindern, daß die Kassette (20) mit der Oberseite nach unten geladen wird.

7. Kombination nach Anspruch 4, bei der die führenden Halteeinrichtungen (13b, 13c) Gräben aufweisen, die an ihren Innenseiten ausgebildet sind, um mit an der Kassette (20) ausgebildeten Vorsprüngen zusmamenzuwirken, um zu verhindern, daß die Kassette (20) mit der Oberseite nach unten geladen wird.

8. Kombination nach einem der Ansprüche 2 bis 7, bei der die führenden Halteeinrichtungen (13b, 13c) vorspringende Stücke (13k, 13l) aufweisen, um mindestens die Oberseite oder die Unterseite der Kassette (20) zu führen und zu halten.

9. Kombination nach einem der Ansprüche 2 bis 8, bei der die führenden Halteeinrichtungen (13b, 13c) des Zwischensteckers (10) Endbereiche aufweisen, die so ausgebildet sind, daß die obere Hälfte (11) und die untere Hälfte (12) ineinander eingreifen.

10. Kombination nach Anspruch 9, bei der die obere Hälfte (11) oder die untere Hälfte (12) des Gehäuses (13) über eine Umbiegung an den Enden der führenden Halteeinrichtungen (13b, 13c) verfügt, um dafür zu sorgen, daß die Endbereiche der oberen Hälfte (11) oder die Endbereiche der unteren Hälfte (12) jeweiligen Endbereichen der anderen Hälfte unter der oberen Hälfte (11) und der unteren Hälfte (12) gegenüberstehen, wobei ein Loch in der oberen Hälfte (11) oder der unteren Hälfte (12) in den gegenüberstehenden Endbereichen ausgebildet ist, und ein Vorsprung zum Eingriff in das Loch in der anderen Hälfte unter der unteren Hälfte (12) und der oberen Hälfte (11) ausgebildet ist, wobei ein Eingreifen des Vorsprungs in das Loch dazu führt, daß die obere Hälfte (11) und die untere Hälfte (12) ineinandergreifen.

11. Kombination nach einem der Ansprüche 1 bis 10, bei der die Länge jeder der führenden Halteeinrichtungen (13b und 13c) so ausgewählt ist, daß dafür gesorgt ist, daß ihre Enden über das Ende (21i) der Kassette (20) überstehen, wenn die Kassette (20) in den Zwischenstecker (10) geladen ist.

12. Kombination nach einem der Ansprüche 2 bis 11, bei der der Zwischenstecker (10) so ausgebildet ist, daß er ein Einführen dieses Bereichs (13a) mit der Oberseite nach unten in das Spielgerät (40) verhindert.

13. Kombination nach Anspruch 12, bei der beide Seiten desjenigen Teils des Bereichs (13a), der so ausgebildet ist, daß er in das zweite Spielgerät paßt, Schrägen (13f, 13g) zum Zusammenwirken mit dem zweiten Spielgerät aufweisen, um zu verhindern, daß das Gehäuse (13) mit der Oberseite nach unten eingeführt werden kann.

14. Kombination nach einem der Ansprüche 2 bis 13, bei der die Leiterplatte (14) eine Adressenumsetzeinrichtung (18) aufweist, um eine Adressenumsetzung zwischen Eingangs- und Ausgangssignalen der ersten Gruppe (14a) von Verbindungsanschlüssen sowie Eingangs- und Ausgangssignalen der zweiten Gruppe (14b) von Verbindungsanschlüssen auszuführen.

15. Kombination nach einem der vorstehenden Ansprüche, bei der der Zwischenstecker (10) so ausgebildet ist, daß er es ermöglicht, daß eine Kassette für ein Spielgerät mit einem Vertikal- oder Horziontalladesystem bei einem Spielgerät für ein Horizontal- oder Vertikalladesystem verwendet werden kann.

16. Kombination nach einem der Ansprüche 1 bis 14, bei der der Zwischenstecker (10) so ausgebildet ist, daß er es ermöglicht, daß eine Kassette für ein Spielgerät mit Vertikal- oder Horziontalladesystem bei einem Spielgerät mit einem Vertikal- oder Horizontalladesystem eines anderen Standards verwendet werden kann.

## Revendications

1. Combinaison d'une machine de jeu (40) ayant une ouverture de chargement de cassette dans laquelle une cassette de jeu d'un premier type prédéterminé peut être chargée pour jouer à un jeu, un deuxième type de cassette de jeu enfichable (20) qui n'est pas dudit premier type prédéterminé et a un adaptateur (10) ayant une première partie (14a) adaptée pour être enfichée dans l'ouverture de chargement de cassette, et une deuxième partie (15) adaptée pour recevoir ladite cassette de jeu enfichable du deuxième type 20, caractérisée en ce que ladite machine de jeu comprend un circuit de verrouillage pour empêcher d'utiliser un jeu avec une cassette qui n'est pas dudit premier type prédéterminé, et ledit adaptateur (10) comprend un circuit (14) connectant lesdites première et deuxième parties (14a, 15) et comporte des moyens (18) agencés pour annuler l'action dudit circuit de verrouillage de manière que lorsque l'adaptateur (10) est enfiché dans l'ouverture de chargement de cassette de la machine de jeu (40) et que ladite cassette de jeu enfichable du deuxième type (20) est reçue dans la deuxième partie (15) de l'adaptateur (10), l'utilisation d'un jeu avec ladite cassette enfichable du deuxième type (20) est permise.

2. Combinaison selon la revendication 1, dans laquelle l'adaptateur (10) comprend:
- un boîtier (13) comprenant une moitié supérieure (11) et une moitié inférieure (12), ledit boîtier étant formé pour avoir une partie (13a) dont au moins une partie est adaptée pour être introduite dans ladite machine de jeu (40) et, à des positions opposées à ladite partie (13a), des moyens formant guide et support (13b, 13c) pour guider le chargement de ladite cassette de jeu enfichable du deuxième type (20) dans l'adaptateur (10) et supporter ladite cassette (20) après qu'elle a été chargée dans celui-ci;
- une carte à circuit imprimé (14) contenu dans ledit boîtier (13) et ayant un bord sur lequel un premier groupe (14a) de bornes de connexion adaptées pour être connectées à ladite machine de jeu (40) sont disposés en un groupement, et un autre bord sur lequel un deuxième groupe (14b) de bornes de connexion adaptées pour être connectées à ladite cassette de jeu enfichable du deuxième type (20) sont disposés en un groupement; et
- un connecteur (15) pour connecter électriquement ledit groupe (14b) de bornes de connexion à ladite cassette (20) lorsqu'elle est chargée dans ledit adaptateur (10), au moins une partie dudit connecteur (15) étant logée dans ledit boîtier (3).

3. Combinaison selon la revendication 2, dans laquelle:
- ladite cassette de jeu enfichable du deuxième type (20) a une forme générale parallélépipédique rectangulaire; et
- lesdits moyens formant guide et support (13b, 13c) de l'adaptateur (10) sont formés pour avoir une forme adaptée pour guider et supporter des côtés opposés de ladite cassette (20) le long de la direction dans laquelle elle est chargée dans ledit adaptateur.

4. Combinaison selon la revendication 2 ou 3, dans laquelle lesdits moyens formant guide et support sont agencés de manière à empêcher le chargement de ladite cassette de jeu enfichable du deuxième type (20) dans l'adaptateur (10) dans une orientation sens dessus dessous.

5. Combinaison selon la revendication 4, dans laquelle lesdits moyens formant guide et support (13b, 13c) ont des chanfreins 13i, 13j) formés sur les faces latérales intérieures de ceux-ci pour coopérer avec des chanfreins analogues formés sur la cassette (20) pour empêcher ladite cassette (20) d'être chargée sens dessus dessous.

6. Combinaison selon la revendication 4, dans laquelle lesdits moyens formant guide et support (13b, 13c) ont des saillies (17a à 17d) formées sur les faces latérales intérieures de ceux-ci pour coopérer avec des gorges (16a à 16d) formée sur la cassette (20) pour empêcher ladite cassette (20) d'être chargée sens dessus dessous.

7. Combinaison selon la revendication 4, dans laquelle lesdits moyens formant guide et support (13b, 13c) ont des gorges formées sur les faces latérales intérieures de ceux-ci pour coopérer avec des saillies formées sur la cassette (20) pour empêcher ladite cassette (20) d'être chargée sens dessus dessous.

8. Combinaison selon l'une quelconque des revendications 2 à 7, dans laquelle lesdits moyens formant guide et support (13b, 13c) ont des pièces faisant saillie (13k, 13l) pour guider et supporter au moins une surface supérieure ou une surface inférieure de ladite cassette (20).

9. Combinaison selon l'une quelconque des revendications 2 à 8, dans laquelle lesdits moyens formant guide et support (13b, 13c) de l'adaptateur (10) ont des parties extrêmes formées de telle manière que ladite moitié supérieure (11) et ladite moitié inférieure (12) sont engagées l'une avec l'autre.

10. Combinaison selon la revendication 9, dans laquelle ladite moitié supérieure (11) ou ladite moitié inférieure (12) du boîtier (13) a un coude aux extrémités desdits moyens formant guide et support (13b, 13c) de manière à amener l'une et l'autre parties extrêmes de ladite moitié supérieure (11) ou parties extrêmes de ladite moitié inférieure (12) à être opposées à des parties extrêmes respectives de l'autre de ladite moitié supérieure (11) et de ladite moitié inférieure (12), un trou étant formé dans ladite moitié supérieure (11) ou ladite moitié inférieure (12) au niveau desdites parties extrêmes opposées, une saillie pour engagement dans ledit trou étant formée dans l'autre de ladite moitié inférieure et ladite moitié supérieure (11), et l'engagement de ladite saillie dans ledit trou amenant ladite moitié supérieure (11) et ladite moitié inférieure (12) a être engagées l'une avec l'autre.

11. Combinaison selon l'une quelconque des revendications 2 à 10, dans laquelle la longueur de chacun desdits moyens formant guide et support (13b, 13c) est choisie de manière à amener les extrémités de ceux-ci à dépasser de l'extrémité (21i) de ladite cassette (20) lorsque ladite cassette (20) est chargée dans ledit adaptateur (10).

12. Combinaison selon l'une quelconque des revendications 2 à 11, dans laquelle l'adaptateur (10) est agencé de manière à empêcher l'introduction sens dessus dessous de ladite partie (13a) de celui-ci dans ladite machine de jeu (40).

13. Combinaison selon la revendication 12, dans laquelle les deux côtés de ladite partie de ladite partie (13a) qui est adaptée pour être introduite dans la deuxième machine de jeu ont des chanfreins (13f, 13g) prévus pour coopérer avec ladite deuxième machine de jeu pour empêcher ledit boîtier (13) d'être introduit sens dessus dessous.

14. Combinaison selon l'une quelconque des revendications 2 à 13, dans laquelle ladite carte à circuit imprimé (14) comprend des moyens de conversion d'adresses (18) pour effectuer la conversion d'adresses entre des signaux d'entrée et de sortie dudit premier groupe (14a) de bornes de connexion et des signaux d'entrée et de sortie dudit deuxième groupe (14b) de bornes de connexion.

15. Combinaison selon l'une quelconque des revendications précédentes, dans laquelle ledit adaptateur (10) est formé de manière à permettre à une cassette pour une machine de jeu ayant un système de chargement vertical ou horizontal d'être utilisée avec une machine de jeu ayant un système de chargement horizontal ou vertical.

16. Combinaison selon l'une quelconque des revendications 1 à 14, dans laquelle ledit adaptateur (10) est formé de manière à permettre à une cassette d'une machine de jeu ayant un système de chargement vertical ou horizontal d'être utilisée avec une machine de jeu ayant un système de chargement vertical ou horizontal d'une norme différente.
